# EUROPEAN PATENT APPLICATION

(11) **EP 3 300 159 A1**
(43) Date of publication of application: **28.03.2018**
(21) Application number: 16306240.9
(22) Date of filing: 27.09.2016
(51) Int. Cl.: H01M 10/42, G01R 31/36, H01M 10/48

(54) **ELECTROCHEMICAL CELL TESTING DEVICE**

(71) Applicant: Centre National de la Recherche Scientifique, 75016 Paris (FR)
(72) Inventor: ALVES DALLA CORTE, Daniel, 94110 ARCUEIL (FR); LUTZ, Lukas, 73527 SCHWABISCH GMUND (DE); TARASCON, Jean-Marie, 75014 PARIS (FR)
(74) Representative: Feray, Valérie

(57) **Abstract**

The invention concerns an electrochemical cell testing device (10), comprising a base (11) comprising at least one test compartment (13), a first and a second current collector (15, 16) arranged within the test compartment (13) such that the current collectors (15, 16) face each other, at least one measurement probe (17) arranged within the test compartment (13), electrical connectors (18, 19, 20) for the current collectors (15, 16) and the at least one measurement probe (17), wherein the electrical connectors (18, 19, 20) are arranged accessible from the outside of the test compartment (13), and a cover (12) closing the at least one test compartment (13) hermetically. The test compartment (13) is adapted to receive electrodes and an electrolyte of an electrochemical cell to be tested.

## Description

The invention concerns a device for the testing of electrochemical cells.

Nearly all domains of technology require powerful and durable energy storage devices. The research and development of materials for batteries and accumulators, based on the electrochemical test of new electrode materials, is in great extension. Multiple tests and cells are needed in order to identify and certify new materials as well as for optimizing the cell composition. The results of all this exploratory research and development of materials relies on accurate and reproducible experiments.

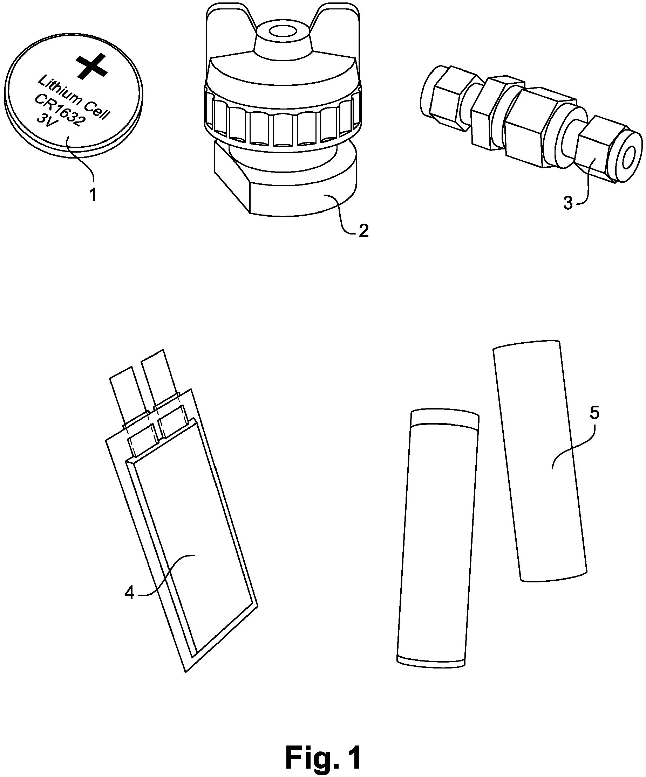

The exploration of new electrochemical reactions, such as for the development of metal-air, metal-sulfur, or Lithium (Li)-rich NMC batteries (containing Nickel, Manganese, and Cobalt), has increased the need for advanced testing cells capable of performing gas management, temperature control, and electrode stacking pressure and internal pressure detection. Currently, the most important part of electrochemical tests for energy storage is performed on five types of cell designs. Examples of common cell designs are shown in Figure 1. These common cell designs include coin cells 1, PAT-cells 2 (of the firm EL-CELL), Swagelok® cells 3 (of the firm Swagelok), pouch cells 4, and 18650 cells 5 (cylindrical cells measuring 18.6 mm x 65.2 mm). Coin cells 1, PAT-cells 2, and Swagelok 3 cells have a cylindrical/round geometry whereas pouch 4 and 18650 cells 5 exhibit prismatic and spiral geometries, respectively. These testing cells 1-5 suffer from laborious assembling, low reproducibility and do not deliver a complete cell characterization. Further, cell components such as electrodes and electrolyte cannot be recovered without damage after the measurements.

Standard testing cells are also employed to carry out *in operando* characterizations, i.e., characterizations of the battery while it is performing charge-discharge cycles. This is generally achieved by means of modified standard cells. For example, external heating elements, temperature probes, pressure sensors, and the like may be added to standard cells such as Swagelok® cells. However, these external elements add complexity to the assembling process of each of the cells and greatly increase their size. Also, the modification of the standard cells implies impaired reproducibility and reliability of the test and measurement results.

Commercially available products that are capable of pressure measurements and gas analysis separately are very complex and highly fragile, which results in high failure rates during the cell tests and characterizations. Further, such products are restricted to very small electrode sizes, thereby limiting the user to test only extremely small quantities of materials, which are not representative of the quantities according to application standards.

The object of the present invention is to provide a device for electrochemical cell testing enabling fast, easy, non-destructive, and reproducible testing of any kind of electrochemical cells and providing a complete characterization of the same.

According to a first aspect, embodiments of the present invention provide an electrochemical cell testing device comprising a base comprising at least one test compartment, and a first and a second current collector arranged within the test compartment such that the current collectors face each other. The testing device further comprises at least one measurement probe arranged within the test compartment and electrical connectors for the current collectors and the at least one measurement probe, wherein the electrical connectors are arranged accessible from the outside of the test compartment. The testing device further comprises a cover closing the at least one test compartment hermetically. The test compartment is adapted to receive electrodes and an electrolyte of an electrochemical cell to be tested.

The base and the cover of the electrochemical cell testing device may be made of aluminium, copper, stainless steel, polytetrafluoroethylene, polyethylene terephthalate, polyether ether ketone, polyphenylene ether, or any other solvent resistant material.

The at least one measurement probe may comprise at least one of an atmospheric pressure probe, a mechanical pressure probe, and a temperature probe.

In some embodiments, the electrochemical cell testing device further comprises a fluid inlet to inject fluid into the test compartment and a fluid outlet to retrieve fluid from the test compartment.

The fluid may be either an electrolyte or a gas.

Advantageously, the electrochemical cell testing device further comprises a compartment sleeve inserted in the test compartment so as to be in contact with the walls delimitating the test compartment. The compartment sleeve is intended to protect the walls of the test compartment from corrosion and wear. The sleeve is exchangeable so that it can be easily replaced when it is worn.

The compartment sleeve may be made of polytetrafluoroethylene, polyethylene terephthalate, polyether ether ketone, polyphenylene ether, or any other solvent resistant non-conducting material.

Advantageously, the test compartment may be of cylindrical or of prismatic form. The cylindrical form is particularly well adapted for testing electrochemical cells having electrodes with cylindrical or spiral geometry, e.g., as in coin or 18650 cells.

According to some embodiments, the electrochemical cell testing device further comprises an adjustment means for adjusting the distance between the first current collector and the second current collector. The adjustment means may comprise, for example, a screw that is accessible from the outside of the cover and that is able to displace the second current collector towards or from the first current collector when turned. The distance between the current collectors and the stack pressure in the cell to be tested may thus be adjusted easily.

Advantageously, the first current collector may be attached to the bottom of the test compartment and the second current collector may be attached to the cover. In some embodiments, the second current collector is attached to the cover by means of a spring. This ensures a predetermined stack pressure in the cell to be tested.

According to a second aspect, embodiments of the present invention provide a method for testing an electrochemical cell using the electrochemical cell testing device according to the first aspect of the invention. The method comprises placing a first electrode onto the first current collector in the test compartment, placing a separator adapted to hold an electrolyte onto the first electrode, placing a second electrode onto the separator, closing the test compartment hermetically by fixing the cover on the base, and measuring cell parameters and/or cell characteristics using the at least one measurement probe.

The device and method according to embodiments of the present invention provide multipurpose electrochemical cell testing. The testing device enables easy, fast, and reproducible mounting and non destructive testing of electrochemical cells of different sizes or models, such as round, cylindrical, and prismatic. For this, the test compartment of the testing device is filled with battery components, i.e., positive and negative electrodes, a separator and an electrolyte. The electrodes can have any design, such as round, prismatic, or 18650 electrodes. Multiple electrochemical tests can be performed simultaneously with *in operando* characterizations such as internal and electrode stacking pressure measurements, temperature control, gas management, and gas and electrolyte sampling. The electrochemical cell testing device is also adapted to multiple battery technologies, i.e., Li-ion, Li-air, Li-sulfur batteries, etc. For the assembly of the testing device, no screws, crimping machines, or the like are needed. The testing device ensures the atmospheric composition within the test compartment and provides the electrical contact between the electrodes and external testing equipment (such as a potentiostat). It may monitor the atmospheric pressure and the mechanical or stacking pressure as well as the internal temperature and electrode temperature in each test compartment.

Advantageously, the electrochemical cell testing device according to the invention allows the recovery of all the components, i.e., the electrodes and the separator with the electrolytes, assembled within the test compartment, after cycling. This is of great interest as post-mortem analysis can then be performed on any of the recovered components.

Exemplary embodiments of the invention according to this disclosure are described with reference to the accompanying drawings, in which:
Fig. 1, already described, schematically illustrates examples of testing cell designs of the prior art,
Figs. 2a-2c schematically illustrate embodiments of the electrochemical cell testing device according to the invention,
Figs. 3a and 3b are schematic sectional views of embodiments of the electrochemical cell testing device according to the invention,
Figs. 4a and 4b are schematic longitudinal and transverse sectional views of embodiments of the electrochemical cell testing device according to the invention,
Fig. 5 shows another schematic sectional view of an embodiment of the electrochemical cell testing device according to the invention,
Fig. 6 schematically illustrates a compartment sleeve according to an embodiment of the invention,
Fig. 7 schematically illustrates a sectional view of an embodiment of the electrochemical cell testing device with a compartment sleeve according to the invention, and
Figs. 8a and 8b are schematic sectional views of embodiments of the electrochemical cell testing device according to the invention.

The figures and the following detailed description illustrate exemplary embodiments. In the figures, elements with similar structures and/or functions may be denoted by like reference numerals.

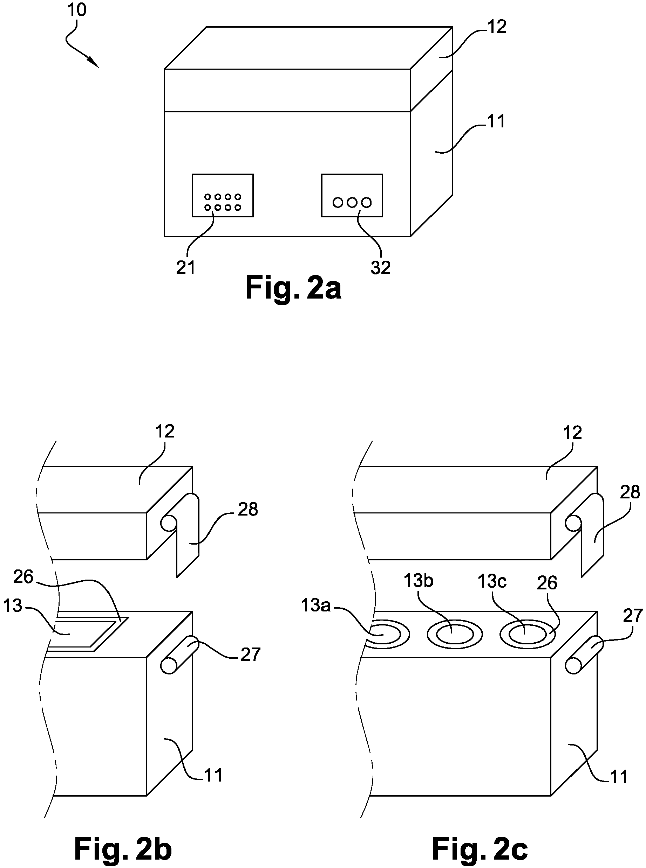

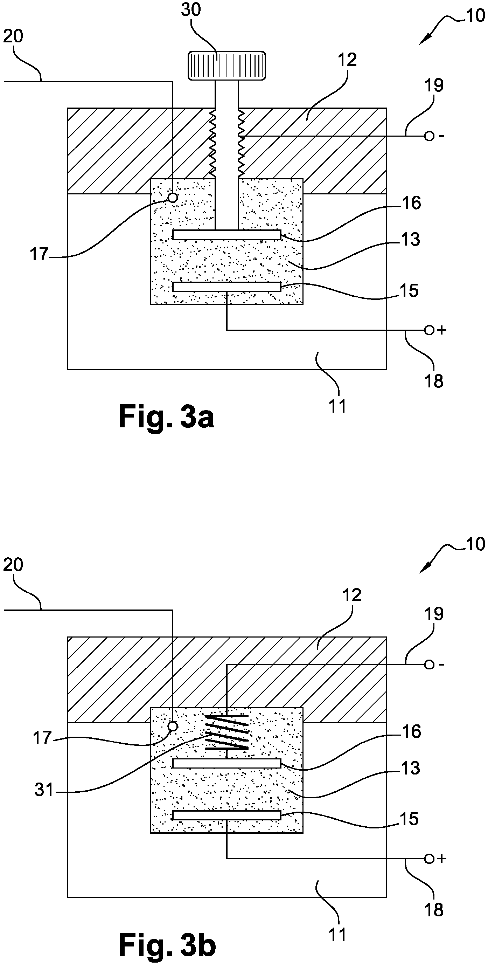

Figures 2a-2c schematically show the exterior appearance of embodiments of the electrochemical cell testing device 10 according to the present disclosure, and Figures 3a and 3b schematically show sectional views of embodiments of the testing device 10. The cell testing device 10 comprises a base 11 and a cover 12. The base 11 comprises at least one test compartment 13. The test compartment 13 is a cavity worked in the base 11, intended to receive components of an electrochemical cell to be tested, i.e., electrodes and an electrolyte.

The base 11 and the cover 12 are made of a solvent resistant material to resist the corrosion that may be caused by the components (electrodes, electrolyte) of the cell to be tested. The solvent-resistant material may be aluminium, copper, stainless steel, polytetrafluoroethylene, polyethylene terephthalate, polyether ether ketone, polyphenylene ether, or the like.

The test compartment 13 houses a first and a second current collector 15, 16. The current collectors 15, 16 face each other within the test compartment. The current collectors 15, 16 are not permanently fixed within the test compartment 13 such that they are exchangeable. Preferably, the first current collector 15 is attached to the bottom of the test compartment 13, and the second current collector 16 is attached to the cover 12. The current collectors 15, 16 may, for example, be screwed into the bottom of the base 11 and the cover 12, respectively. The current collectors 15, 16 may be made of stainless steel, copper, or aluminium.

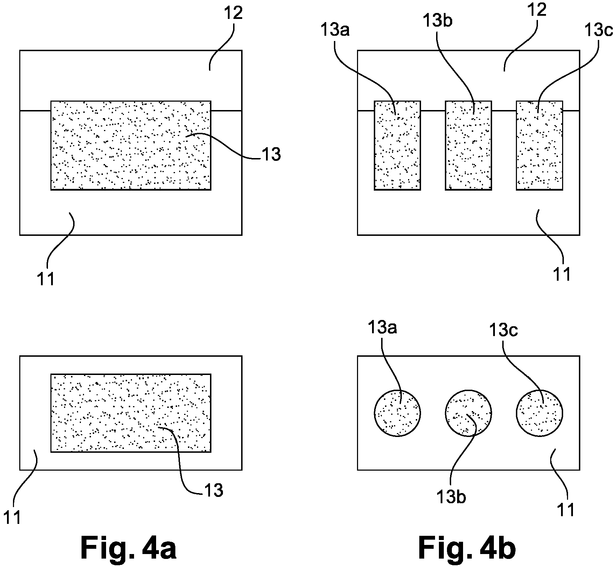

The test compartment 13 of the cell testing device 10 according to the invention may have different geometric forms. Preferably, the test compartment 13 is of cylindrical or of prismatic form. A test compartment 13 of prismatic form is illustrated in Figure 4a in a longitudinal and transverse section view, respectively. A test compartment 13 of cylindrical form is illustrated in Figure 4b in a longitudinal and transverse section view, respectively. The geometric form of the test compartment 13 accounts for the design and the size of the electrodes that it may accommodate. For example, the cylindrical test compartment form is particularly adapted to circular or cylindrical electrode geometries and sizes, such as used in coin, prismatic and 18650 (i.e., spiral) cells. As an example, electrodes of the coin design may have an area of about 2 cm². The prismatic test compartment form is particularly adapted to squared or prismatic electrodes, such as in pouch cells. As an example, electrodes of prismatic design may measure about 5 cm x 7 cm.

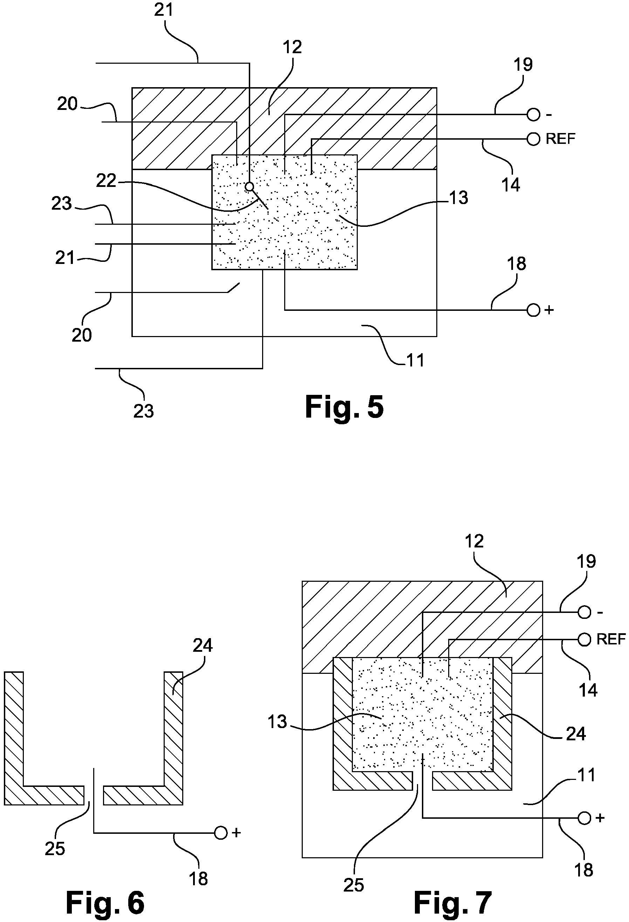

Figure 5 shows another sectional view of an embodiment of the testing device according to the present invention. At least one measurement probe 17 is arranged within the test compartment 13. For example, the testing device 10 may comprise an atmospheric pressure probe, a mechanical pressure probe, or a temperature probe. The atmospheric pressure probe is used to monitor the atmospheric pressure within the test compartment, for example, during an evacuation of the test compartment or during cell test under various atmospheric environments. The mechanical pressure probe is used to monitor and adjust the stacking pressure. Several measurement probes of the same type may be present. For example, multiple temperature probes may be distributed as a matrix at the bottom of the test compartment 13 in order to be able to generate a detailed map of the temperature distribution in the electrode placed on the first current collector 15. The temperature probe matrix fits all cell designs or geometries, such as square, circular, or cylindrical cell geometries.

Further, electrical connectors 18, 19, 20 for the current collectors 15, 16 and the at least one measurement probe 17 are provided in the electrochemical cell testing device 10. The electrical connectors 18, 19, 20 are distributed within the test compartment 13 in order to fit different cell and testing arrangements. The electrical connectors 18, 19, 20 pass through the walls of the base 11 and/or the cover 12 and are arranged accessible from the outside of the test compartment 13. Figure 2a illustrates an example of an electrical connection panel 21 or terminal integrated in the wall of the base 11, allowing for the fast connection of all electrical connectors present within the device 10. The cover 12 is such that the test compartment is closed hermetically when the base 11 and the cover 12 are assembled, i.e., when the cell testing device 10 is closed.

An electrical connector 14 for a reference electrode may also be provided. The reference electrode is placed within the separator and is used to determine the absolute electrical potential of each of the positive and negative electrodes of the electrochemical cell to be tested.

In some embodiments, the electrochemical cell testing device 10 according to the invention comprises one or a plurality of fluid inlets 21, such as illustrated in Figure 5. For example, the cover 12 may be provided with a liquid inlet 21. The liquid inlet 21 may be connected to a directional injection tube 22 in the test compartment 13. The directional injection tube 22 can be adjusted to reach any position within the test compartment 13. The liquid inlet 21 may be used, for example, to add electrolyte in the electrochemical cell under test. This is particularly useful for cells with large electrode geometries, such as 18650 cells. The fluid inlet may also be a gas inlet 21.

Still with reference to Figure 5, in some embodiments, the electrochemical cell testing device 10 according to the invention comprises one or a plurality of fluid outlets 23. The fluid outlet 23 may be a gas outlet 23 allowing the test compartment 13 to be evacuated. For example, the electrolyte may be injected through the liquid inlet 21, connected to an electrolyte reservoir, and the directional tube 22, while the test compartment 13 is evacuated through the gas outlet 23. This ensures that the separator is completely impregnated with the electrolyte and no air bubbles remain in the separator. At the same time, only a small quantity of electrolyte will be sufficient to make the cell work. The fluid outlet 23 may also be a liquid outlet in order to retrieve electrolyte.

The liquid inlets 21 and outlets 23 may be controlled by external valves or built-in valves within the testing device 10 (not shown).

A fluid management unit may be provided with the cell testing device, including all the fluid inlets and fluid outlets, as well as the valves that regulate gas or liquid injection into the test compartment 13. The fluid management unit allows for connecting the test compartment to different sources of gases (e.g., oxygen, argon, CO₂), to an electrolyte reservoir, or to a vacuum pump and for controlling the valves. Therefore, it is, for example, possible to exchange the gas present within the test compartment 13 once the testing device has been prepared with electrodes and electrolyte and is closed.

Advantageously, all the fluid inlets and outlets present in the device 10 may be arranged such as to be centralized at one side of the test compartment 13. They may then be connected to a fluid connection panel 32 or terminal, as illustrated in Figure 2a. The handling of the testing device is thus greatly improved.

Preferably, the electrochemical cell testing device 10 according to the invention further comprises a compartment sleeve. Such a compartment sleeve 24 is shown in Figures 6 and 7. The compartment sleeve 24 is intended to be inserted into the test compartment 13 so that the sleeve 24 is in contact with the inner walls of the test compartment 13, such as illustrated in Figure 7. The compartment sleeve 24 provides the test compartment 13 with a protective layer in order to avoid excessive chemical degradation of the base 11 of the testing device 10 during its calendar life. The compartment sleeve 24 is also adapted to protect from internal short-circuits (e.g., when an electrode comes in touch with the base 11 made of metal) during the device assembly as well as during connection to an external potentiostat, thereby decreasing measurement errors.

One compartment sleeve 24 is placed in each test compartment 13, 13a-13c. The compartment sleeve 24 is exchangeable in order to be easily replaced when it is no longer usable. Different sizes and models of compartment sleeves 24 are necessary to account for the form of the test compartment 13 and the type of the cell to be tested. The compartment sleeve 24 may be made of polytetrafluoroethylene, polyethylene terephthalate, polyether ether ketone, polyphenylene ether, or the like. Advantageously, the compartment sleeve 24 comprises openings 25 allowing for the first current collector 15 and, eventually, for a fluid inlet and/or outlet to be fed through.

Advantageously, the electrochemical cell testing device 10 according to the invention encloses a plurality of test compartments 13 within the base 11. This is illustrated in Figures 2c and 4a. The test compartments 13a-13c may be of the same size and geometry. Each test compartment 13a-13c may be equipped with the measurement probes and fluid inlets and outlets as described above. This allows for the testing and characterization of large benches of samples individually, i.e., a plurality of electrochemical cells of the same type and technology, at the same time in order to obtain statistical results and reproducibility of the same. It is also possible to test at once a plurality of different cell types. The test compartments 13a-13c may also be of different sizes and geometries.

As illustrated in Figures 2b and 2c, the electrochemical cell testing device 10 according to the invention further comprises a seal 26 that is arranged at the edge of the test compartment 13. The seal ensures that the test compartment 13 is hermetically sealed with respect to the environment once the base 11 and the cover 12 of the device 10 are assembled and the seal 26 is compressed between the base 11 and the cover 12. The seal 26 may be, for example, an O-ring.

Figures 2b and 2c schematically illustrate closing means 27 arranged on the base 11 and complementary closing means 28 arranged on the cover 12 of the device 10. Preferably, these means 27, 28 include pressure clips 27, 28 able to press the base 11 and the cover 12 together when they interact. The pressure clips 27, 28 may be fixed directly on the base 11 and the cover 12 of the testing device 10. Alternatively, the pressure clips may be mounted on a metallic frame structure (not shown) holding the base 11 and the cover 12 together once the metallic frame is closed.

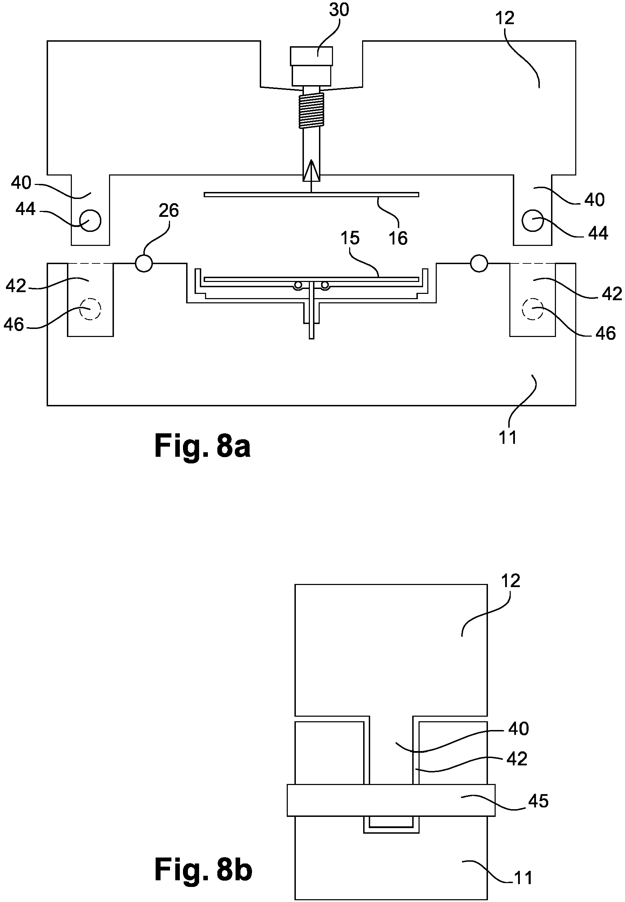

Alternatively, the base 11 and the cover 12 can be locked together by a lock-pin mechanism as shown in Figs. 8a and 8b. The cover 12 of the test device 10 comprises plugs 40, which fit into notches 42 provided in the base 11. Once the base 11 and the cover 12 assembled and the pugs 40 inserted into the corresponding notches 42, pins 45 are inserted through holes 44, 46 in the plugs 40 and the base 11. The lock pin-mechanism is adapted for supporting high mechanical pressures. It keeps the test compartment 13 hermetically sealed even when high electrode stacking pressure is applied.

In order to guarantee the leak-tightness of the test compartment 13, a seal (not shown), such as an O-ring, may be arranged on either side of the openings of the compartment sleeve 24. For example, to seal the opening 24 for the first current collector 15, an O-ring may be placed between the bottom of the test compartment 13 and the compartment sleeve 24, and another O-ring may be placed between the compartment sleeve 24 and the first current collector 15.

According to an embodiment, the cell testing device 10 according to the invention further comprises an adjustment means for adjusting the distance between the first current collector 15 and the second current collector 16. Advantageously, as depicted in Figure 3a, the adjustment means comprises a screw 30. The screw 30 is accessible from the outside of the cover 12. When the screw 30 is turned, the distance between the first and the second current collectors 15, 16 is varied. The internal mechanical pressure applied between the current collectors 15, 16 may thus be tuned. A mechanical pressure sensor (not shown) may be placed under the first current collector 15 at the bottom of the test compartment 13 in order to measure the pressure applied through the screw 30. The screw 30 may be equipped with an integrated torque range scale allowing the direct adjustment of the electrode stacking pressure when turning the screw 30. The electrode stacking pressure, i.e., the internal mechanical pressure, may also be monitored during the electrochemical tests using the pressure sensor.

According to another embodiment, illustrated in Figure 3b, the second current collector 16 is attached to the cover 12 by means of a compression spring 31. Once the test compartment 13 is closed, the compression spring 31 pushes the second current collector 16 towards the first current collector 15 and thus keeps the electrodes of the cell to be tested compressed together.

The present invention also relates to a method for testing an electrochemical cell using the electrochemical cell testing device according to embodiments disclosed above. A first electrode of the cell to be tested is placed onto the first current collector 15 in the test compartment 13. A separator that is intended to hold an electrolyte is then placed onto the first electrode. A second electrode is placed onto the separator. A plurality of test compartments 13a-13c may be furnished in this way. Finally, the test compartment 13 is closed hermetically by fixing the cover 12 on the base 11. The electrochemical cell testing device 10 is now ready to perform the cell testing or for the characterization of the cell *in operando* during charge-discharge cycles, using the at least one measurement probe 17 placed within the test compartment 13. Once the testing/characterization terminated, the electrodes, the separator, and the electrolyte may be retrieved from the test compartment 13. Post-mortem analysis may then be performed on any of the recovered components.

In some embodiments, the separator is already impregnated with the electrolyte when it is placed on the first electrode in the test compartment. In other embodiments, the separator may be impregnated with the electrolyte after the test compartment has been filled and closed by means of liquid inlet having a directional tube directed towards the separator and connected to an electrolyte reservoir. This is particularly useful for 18650 type cells.

Exemplary embodiments of the method according to the invention will be described in the following.

According to a first example, the method allows for a general test of a new electrode material under different testing parameters. A plurality of test compartments of a testing device is equipped with compartment sleeves and first (e.g., positive) current collectors. The compartment sleeves are placed in the interior of each test compartment in the base and fixed with the first current collectors.

For the following steps, the device may be placed in a glove box filled with inert gas (e.g., argon). This is necessary if at least one of the materials used to prepare the electrochemical cell (electrodes, electrolyte) is air or moisture sensitive.

A first (e.g., positive) electrode is placed over the first current collector in each test compartment, followed by a separator impregnated with an electrolyte and a second (e.g., negative) electrode for each test compartment. Sealing O-rings are then placed at the edge of each test compartment between the base and the cover. The test compartments are then closed and locked with pressure clips so that the base and the cover hold together tightly. The test compartments are then hermetically sealed and can be removed from the glove-box.

According to this first example, multiple electrochemical cells can be easily and quickly assembled and tested in a hermetic compartment. The temperature is controlled, and the electrical potential, current, and atmospheric pressure are recorded for all the tested cells at once.

According to a second example, the method allows for a general test of square or prismatic sized electrode cells for the *in situ* characterization of an electrolyte for Li-ion batteries. In this second example, only one test compartment having prismatic geometry is needed. The test compartment is prepared and filled as described for the first example, the electrodes having square or prismatic size. The temperature is controlled, and the electrical potential, current, and atmospheric pressure are recorded in order to characterize the reactivity of the electrolyte towards the electrodes during charge-discharge cycles.

According to a third example, the method allows for testing of metal-air batteries. A plurality of test compartments are prepared and filled as described for the first example. The current collectors are metal-air current collectors. Such current collectors are perforated with a plurality of holes in order to allow oxygen to pass through. The testing device is equipped with gas inlets and outlets for each test compartment. After closing the test compartments, the gas inlet and outlet valves (herein referred to as gas management unit) are closed. The device may then be removed from the glove-box. By connecting the gas management unit to a gas filling station, the atmosphere within the test compartments can be controlled and varied any time during the testing or characterization. Multiple cells may thus be assembled, tested, and characterized at the same time under various atmospheric environments. The electrical potential, the current, the internal temperature, and atmospheric pressure are recorded.

According to a fourth example, the method allows for *in situ* measurements of evolved gas by mass spectrometry during electrochemical testing of electrolytes of Li-ion batteries. A plurality of test compartments are prepared and filled as described for the third example. The current collectors are gas-analysis current collectors, i.e., perforated current collectors. Once the testing device 10 is retrieved from the glove-box, the inert gas (e.g., argon) within the test compartment may be replaced by oxygen using the fluid management unit. By connecting the fluid management unit to a purging gas line and a mass spectrometer, the gases evolved within the test compartments can be characterized and quantified constantly or at discrete time intervals during the testing. Multiple cells may thus be assembled and tested, and evolving gases may be analyzed during electrochemical measurements at the same time. The electrical potential, current, internal temperature, and atmospheric pressure are recorded, at the same time as the evolved gas is externally characterized by mass spectrometry.

According to a fifth example, the method allows for temperature mapping during cell tests in squared (i.e., large) electrodes, e.g., for *in situ* temperature mapping of Li-ion batteries or other cells having large squared electrodes. A plurality of test compartments are prepared and filled as described for the first example. A temperature sensor matrix is imbedded in the bottom of each test compartment. This allows for a detailed analysis of the temperature evolution specifically at the first electrode placed on the first current collector at the bottom of the test compartment. The temperature is controlled, and the electrical potential, current, internal temperature, electrode temperature, and atmospheric pressure are recorded for all the tested cells at once.

According to a sixth example, the method allows for testing cells under controlled stacking pressure conditions, e.g., prismatic Li-ion batteries. A plurality of test compartments are prepared and filled as described for the first example. The stacking pressure is adjusted to a desired value by means of the adjustment means allowing the adjustment of the distance between the first and second current collectors, e.g. a screw having an integrated pressure sensor as described above. Various electrochemical tests are performed under various stacking pressure conditions. The temperature is controlled, and the electrical potential, current, internal temperature, electrode temperature, atmospheric pressure, and stacking pressure are recorded for all the tested cells at once.

According to a seventh example, the method allows for stacking pressure monitoring during charge-discharge cycles of cells, e.g., Li-ion batteries. A plurality of test compartments are prepared and filled as described for the sixth example. After adjusting the stacking pressure to a desired value, the possible expansion of the electrode material can be monitored in situ and thus directly correlated to other electrochemical measurements. The temperature is controlled, and the electrical potential, current, internal temperature, electrode temperature, atmospheric pressure, and stacking pressure are recorded for all the tested cells at once.

## Claims

1. An electrochemical cell testing device (10), **characterized in that** it comprises:
- a base (11) comprising at least one test compartment (13),
- a first and a second current collector (15, 16) arranged within the test compartment (13) such that the current collectors (15, 16) face each other,
- at least one measurement probe (17) arranged within the test compartment (13),
- electrical connectors (18, 19, 20) for the current collectors (15, 16) and the at least one measurement probe (17), wherein the electrical connectors (18, 19, 20) are arranged accessible from the outside of the test compartment (13), and
- a cover (12) closing the at least one test compartment (13) hermetically,
wherein the test compartment (13) is adapted to receive electrodes and an electrolyte of an electrochemical cell to be tested.

2. The electrochemical cell testing device (10) according to claim 1, wherein the at least one measurement probe (17) comprises at least one of an atmospheric pressure probe, a mechanical pressure probe, and a temperature probe.

3. The electrochemical cell testing device (10) according to claim 1 or 2, further comprising a fluid inlet (21) to inject fluid into the test compartment, and a fluid outlet (23) to retrieve fluid from the test compartment.

4. The electrochemical cell testing device (10) according to claim 3, wherein the fluid is one of an electrolyte and a gas.

5. The electrochemical cell testing device (10) according to any of the preceding claims, further comprising a compartment sleeve (24) inserted in the test compartment (13) so as to be in contact with the walls delimitating the test compartment (13).

6. The electrochemical cell testing device (10) according to claim 5, wherein the compartment sleeve (24) is made of one of polytetrafluoroethylene, polyethylene terephthalate, polyether ether ketone, and polyphenylene ether.

7. The electrochemical cell testing device (10) according to any one of the preceding claims, wherein the base (11) and the cover (12) are made of one of aluminium, copper, stainless steel, polytetrafluoroethylene, polyethylene terephthalate, polyether ether ketone, and polyphenylene ether.

8. The electrochemical cell testing device (10) according to any of the preceding claims, wherein the test compartment (13) is of cylindrical or of prismatic form.

9. The electrochemical cell testing device (10) according to any of the preceding claims, further comprising an adjustment means (30) for adjusting the distance between the first current collector (15) and the second current collector (16).

10. The electrochemical cell testing device (10) according to any of the preceding claims, wherein the first current collector (15) is attached to the bottom of the test compartment (13) and the second current collector (16) is attached to the cover (12).

11. The electrochemical cell testing device (10) according to claim 10, wherein the second current collector (16) is attached to the cover (12) by means of a compression spring (31).

12. Method for testing an electrochemical cell using the electrochemical cell testing device (10) according to any of claims 1 to 11, the method comprising:
- placing a first electrode onto the first current collector (15) in the test compartment (13),
- placing a separator adapted to hold an electrolyte onto the first electrode,
- placing a second electrode onto the separator,
- closing the test compartment (13) hermetically by fixing the cover (12) on the base (11), and
- measuring cell parameters and/or cell characteristics using the at least one measurement probe (17).
